# EUROPEAN PATENT APPLICATION

(11) **EP 4 835 554 A1**
(43) Date of publication of application: **04.11.2026**
(21) Application number: 26173019.6
(22) Date of filing: 17.04.2026
(51) Int. Cl.: G02F 1/1335, G02B 30/27, H04N 13/305

(54) **DISPLAY DEVICE AND OPTICAL FILM**

(30) Priority: 30.04.2025 US 202563797108 P; 16.04.2026 US 202619649137
(71) Applicant: Innolux Corporation, Jhunan Town, Miaoli County 35053 (TW)
(72) Inventor: LIOU, Hao-Yu, 35053 Jhunan Town, Miaoli County (TW); SUMI, Naoki, 35053 Jhunan Town, Miaoli County (TW); CHENG, Ting-Yu, 35053 Jhunan Town, Miaoli County (TW); YANG, Hung-Wen, 35053 Jhunan Town, Miaoli County (TW)
(74) Representative: Becker, Eberhard

(57) **Abstract**

An optical film (10) including a lens structure (12) is provided. The lens structure (12) includes a base layer (14), a plurality of lens elements (16) disposed on the base layer (14), and a filling layer (18) in direct contact with the plurality of lens elements (16). A refractive index of a lens element (16a) among the plurality of lens elements (16) is n_{L}. The lens element (16a) includes an arc-shaped surface (S16), and the arc-shaped surface (S16) has an apex (AP). A refractive index of the filling layer (18) is n_{F}, wherein n_{F} is smaller than n_{L}. The filling layer (18) includes a flat surface (S18), and a minimum distance (Dm) between the apex (AP) and the flat surface (S18) is greater than 0.1µm and smaller than 100µm. A display device (30) is also provided.

## Description

### BACKGROUND

### Technical Field

This disclosure relates to a display device and an optical film.

### Description of Related Art

An optical film that can be attached to a display panel to achieve a 3D display function is needed.

### SUMMARY

The disclosure provides an optical film that can be attached to a display panel to achieve 3D display, a display device including the optical film and the display panel is also provided.

In an embodiment of the disclosure, a display device includes a display panel and a lens unit. The display panel includes an image formation surface, a top surface, and N layers between the image formation surface and the top surface, wherein N is a positive integer greater than 1. A thickness of an i^{th} layer among the N layers is Tᵢ, a refractive index of the i^{th} layer among the N layers is nᵢ, and i= 1 to N. The lens unit includes a base layer, a plurality of lens elements, a filling layer, and a glue layer. The glue layer is in direct contact with the top surface. The filling layer is in direct contact with the plurality of lens elements. A thickness of the base layer is T_{B}, and a refractive index of the base layer is n_{B}. A thickness of the glue layer is T_{G}, and a refractive index of the glue layer is n_{G}. A refractive index of the filling layer is n_{F}. A maximum thickness of a lens element among the plurality of lens elements is T_{L}, and a refractive index of the lens element is n_{L}, and a focal length of the lens element is FL. The lens element includes an arc-shaped surface, a radius of curvature of the arc-shaped surface is R, and the arc-shaped surface has an apex. An optical gap between the image formation surface and the apex is D_{OG}. ${D}_{OG} = \frac{{T}_{G}}{{n}_{G}} + \frac{{T}_{B}}{{n}_{B}} + \frac{{T}_{L}}{{n}_{L}} + {\sum }_{i = 1}^{N} \frac{{T}_{i}}{{n}_{i}} , FL = \frac{R ∗ {n}_{F}}{{n}_{L} - {n}_{F}}$, n_{F} < n_{L}, and (0.8* D_{OG}) < FL < (1.2* D_{OG}).

In an embodiment of the disclosure, a display device includes a display panel and a lens unit. The display panel includes an image formation surface, a top surface, and N layers between the image formation surface and the top surface, wherein N is a positive integer greater than 1. A thickness of an i^{th} layer among the N layers is Tᵢ, a refractive index of the i^{th} layer among the N layers is nᵢ, and i= 1 to N. The lens unit includes a base layer, a plurality of lens elements, a filling layer, and a glue layer. The glue layer is in direct contact with the top surface. The filling layer is in direct contact with the plurality of lens elements. A thickness of the glue layer is T_{G}, and a refractive index of the glue layer is n_{G}. A minimum thickness of the filling layer is T_{F}, and a refractive index of the filling layer is n_{F}. A refractive index of a lens element among the plurality of lens elements is n_{L}, and a focal length of the lens element is FL. The lens element includes an arc-shaped surface, a radius of curvature of the arc-shaped surface is R, and the arc-shaped surface has an apex. An optical gap between the image formation surface and the apex is D_{OG}. ${D}_{OG} = \frac{{T}_{G}}{{n}_{G}} + \frac{{T}_{F}}{{n}_{F}} + {\sum }_{i = 1}^{N} \frac{{T}_{i}}{{n}_{i}} , FL = \frac{R ∗ {n}_{F}}{{n}_{L} - {n}_{F}}$, n_{F} < n_{L}, and (0.8* D_{OG}) < FL < (1.2* D_{OG}).

In an embodiment of the disclosure, an optical film includes a lens structure. The lens structure includes a base layer, a plurality of lens elements disposed on the base layer, and a filling layer in direct contact with the plurality of lens elements. A refractive index of a lens element among the plurality of lens elements is n_{L}. The lens element includes an arc-shaped surface, and the arc-shaped surface has an apex. A refractive index of the filling layer is n_{F}, wherein n_{F} is smaller than n_{L}. The filling layer includes a flat surface, and a minimum distance between the apex and the flat surface is greater than 0.1µm and smaller than 100µm.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate example embodiments of the disclosure and, together with the description, serve to explain the principles of the disclosure.
FIG. 1 to FIG. 8 are partial cross-sectional views of various optical films according to some embodiments of the disclosure.
FIG. 9 is a partial cross-sectional view of a display device according to some embodiments of the disclosure.
FIG. 10 to FIG. 12 are various partial top views of the display device in FIG. 9.
FIG. 13 is a partial cross-sectional view of a display device according to some embodiments of the disclosure.

### DESCRIPTION OF THE EMBODIMENTS

Reference will now be made in detail to the exemplary embodiments of the disclosure, examples of which are illustrated in the accompanying drawings. Whenever possible, the same reference numerals are used in the drawings and descriptions to refer to the same or similar parts.

Throughout this specification and the claims, certain words are used to refer to specific components. One of ordinary skill in the art will appreciate that manufacturers of electronic devices may refer to the same component by different names. This disclosure is not intended to differentiate between components that have the same function but have different names. In the following description and claims, the words "include" and "comprise" are open-ended terms and should therefore be interpreted to mean "includes, but is not limited to...".

The directional terms mentioned in this disclosure, such as "up", "down", "front", "back", "left", "right", etc., are only for reference to the directions in the accompanying drawings. Accordingly, the directional terms used are illustrative and not limiting of the disclosure. In the drawings, each figure illustrates the general features of methods, structures, and/or materials used in particular embodiments. However, these drawings should not be interpreted as defining or limiting the scope or nature encompassed by these embodiments. For example, the relative sizes, thicknesses, and locations of various layers, regions, and/or structures may be reduced or exaggerated for clarity.

One structure (or layer, component, substrate) described in the disclosure is located on/above another structure (or layer, component, substrate), which may mean that the two structures are adjacent to each other and are directly connected, or that the two structures are adjacent to each other and are not directly connected. Non-directly connected means that there is at least one intermediary structure (or intermediary layer, intermediary component, intermediary substrate, intermediary spacer) between the two structures, with the lower surface of one structure adjacent to or directly connected to the upper surface of the intermediary structure, and the upper surface of the other structure adjacent to or directly connected to the lower surface of the intermediary structure. The intermediary structure may be a single or multi-layered solid or non-solid structure, without limitation. In the disclosure, when a structure is disposed "on" other structures, it may mean that a structure is "directly" on the other structures, or that a structure is "indirectly" on the other structures, that is, a structure and other structures have at least one other structure sandwiched between them.

The terms "approximately", "substantially" or "generally" are generally interpreted as being within 10% of the given value or range, or within 5%, 3%, 2%, 1% or 0.5% of the given value or range. In addition, the terms "the range is from the first value to the second value", "the range is between the first value and the second value" indicate that the range includes the first value, the second value, and other values in between.

The ordinal numbers used in the specification and claims, such as "first" and "second", are used to qualify the components, and do not in themselves imply or represent any previous ordinal number of the component or components, nor do they represent the order of one component or component with another, or the order of the manufacturing method. The use of these numbers is intended only to enable a component with a certain designation to be clearly distinguished from another component with the same designation. The same terminology may not be used in the claims and the specification. Accordingly, the first component in the specification may be the second component in the claims.

In this disclosure, the thickness, length, and width can be measured by using an optical microscope (OM), and the thickness or width can be measured by cross-sectional images in an electron microscope, but not limited thereto. In addition, there may be a certain amount of error between any two values or directions used for comparison. Furthermore, the expression "the given range is the first value to the second value", "the given range falls within the range of the first value to the second value" or "the given range is between the first value to the second value" means that the given range includes the first value, the second value, and other values in between. If the first direction is perpendicular to the second direction, the angle between the first direction and the second direction can be between 80 degrees and 100 degrees; if the first direction is parallel to the second direction, the angle between the first direction and the second direction can be between 0 degrees and 10 degrees.

Unless otherwise defined, all terms used herein, including technical and scientific terms, have the same meanings as are commonly understood by those skilled in the art. It is to be understood that these terms, such as those defined in commonly used dictionaries, should be interpreted as having a meaning consistent with the context or background of the relevant technology and the present disclosure, and should not be interpreted in an idealized or overly formalized manner, except as specifically defined in the embodiments of the present disclosure.

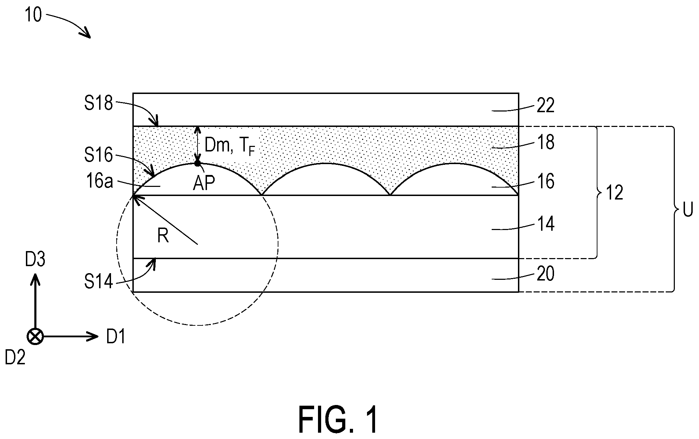

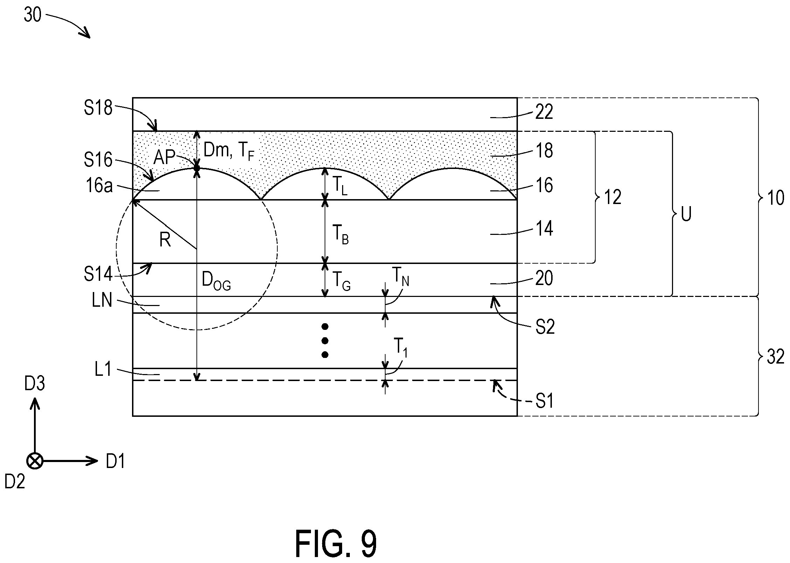

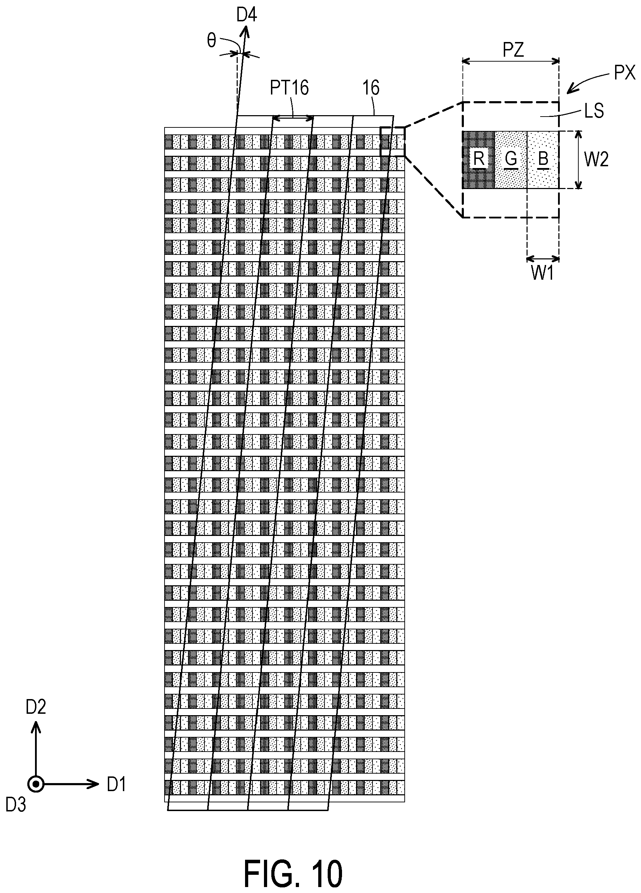

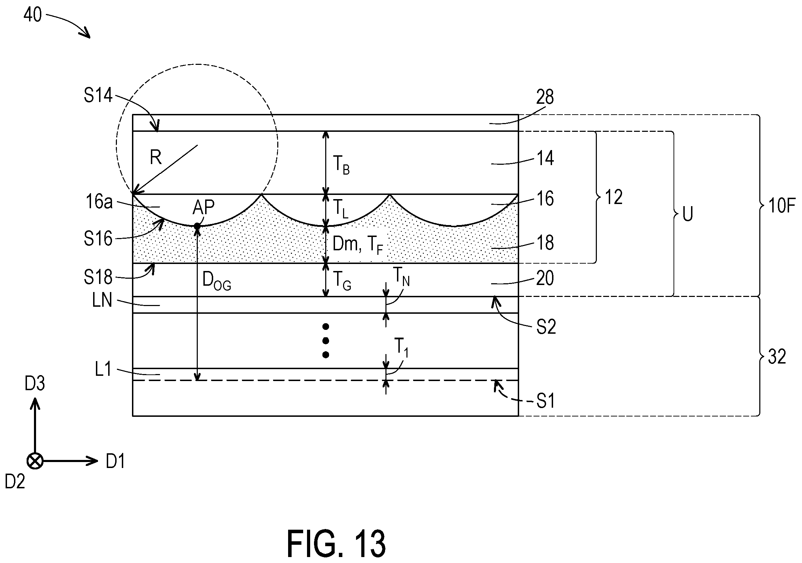

FIG. 1 to FIG. 8 are partial cross-sectional views of various optical films according to some embodiments of the disclosure. FIG. 9 is a partial cross-sectional view of a display device according to some embodiments of the disclosure. FIG. 10 to FIG. 12 are various partial top views of the display device in FIG. 9. FIG. 13 is a partial cross-sectional view of a display device according to some embodiments of the disclosure.

In top views of the present disclosure, some elements or layers are not shown for simplicity and clarity of the top views. For the elements or layers not shown in the top views, please refer to corresponding cross-sectional views and relevant descriptions in the specification for details. It should be noted that the following embodiments can be replaced, reorganized, and mixed with features of several different embodiments without departing from the spirit of the disclosure to complete other embodiments. Features in various embodiments may be mixed and matched as long as they do not violate the spirit of the invention or conflict with each other.

Please refer to FIG. 1, an optical film 10 includes a lens structure 12. The lens structure 12 includes a base layer 14, a plurality of lens elements 16 disposed on the base layer 14, and a filling layer 18 in direct contact with the plurality of lens elements 16. A refractive index of a lens element (e.g., lens element 16a) among the plurality of lens elements 16 is n_{L}. The lens element 16a includes an arc-shaped surface S16, and the arc-shaped surface S16 has an apex AP. A refractive index of the filling layer 18 is n_{F}, wherein n_{F} is smaller than n_{L}. The filling layer 18 includes a flat surface (e.g., a surface S18), and a minimum distance Dm between the apex AP and the flat surface (e.g., the surface S18) is greater than 0.1µm and smaller than 100µm.

Specifically, the base layer 14 is configured to carry the plurality of lens elements 16 and the filling layer 18. A material of the base layer 14 may include glass or polymers (e.g., resin or PC), but not limited thereto.

The plurality of lens elements 16 are disposed on the same surface of the base layer 14. The plurality of lens elements 16 may have substantially the same design parameters (e.g., thickness, refractive index, arc-shaped surface, radius of curvature R, or the like). The plurality of lens elements 16 and the base layer 14 may be made of the same material or different materials. In some embodiments, the plurality of lens elements 16 and the base layer 14 are integrally formed, wherein the plurality of lens elements 16 are in direct contact with the base layer 14, and the refractive index n_{L} of the plurality of lens elements 16 is substantially the same as a refractive index n_{B} of the base layer 14.

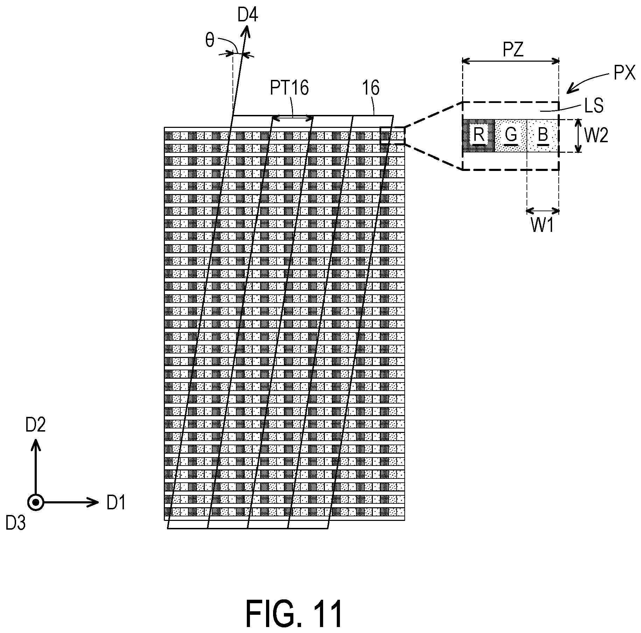

The plurality of lens elements 16 are, for example, a plurality of lenticular lenses. As shown in FIG. 1, a cross-sectional shape of each of the plurality of lens elements 16 may be semi-circular. Semi-circular generally refers to an incomplete circle, and not limited to half of a circle. In FIG. 1, a direction D1 and a direction D2 are, for example, two directions parallel to adjacent sides of the optical film 10, wherein the direction D1 and the direction D2 are, for example, perpendicular to each other and are both perpendicular to a thickness direction (e.g., a direction D3) of the optical film 10. In some embodiments, as shown in FIG. 10 or FIG. 11, the plurality of lens elements 16 are arranged along the direction D1 and extend along a direction D4 perpendicular to the direction D3 and not parallel to the direction D1 and the direction D2 to improve moiré patterns, but are not limited thereto. In other embodiments, the plurality of lens elements 16 are arranged along the direction D1 and extend along the direction D2.

The filling layer 18 is configured to fill the gaps between the plurality of lens elements 16 to reduce interface reflections at the arc-shaped surfaces S16. Namely, the filling layer 18 and the plurality of lens elements 16 are located on the same side of the base layer 14. In some embodiments, as shown in FIG. 1, the filling layer 18 covers the plurality of lens elements 16, and a minimum distance Dm between the apex AP and the surface S18 is greater than 0.1µm to reduce the impact on the light refraction effect of the plurality of lens elements 16 due to incomplete coverage of the filling layer 18. In FIG. 1, the minimum distance Dm between the apex AP and the surface S18 is also a minimum thickness T_{F} of the filling layer 18. Namely, the minimum thickness T_{F} of the filling layer 18 is greater than 0.1µm. Considering factors such as overall thickness, manufacturing time, interface reflection, and/or light refraction effect, the minimum thickness T_{F} of the filling layer 18 is, for example, greater than 0.1µm and smaller than 100µm.

The filling layer 18 can be a single layer or multiple layers. When the filling layer 18 is multiple layers, the For example, the filling layer 18 may be made of polymers, adhesives, or the like, but not limited thereto. The refractive index n_{F} of the filling layer 18 may be smaller than the refractive index n_{L} of the plurality of lens elements 16 to reduce a refractive index difference between the plurality of lens elements 16 and the surrounding medium, thus reducing interface reflection at the arc-shaped surfaces S16 of the plurality of lens elements 16. For example, 1.45 ≤ n_{L} ≤ 1.70, and 1.35 ≤ n_{F} ≤ 1.55, but not limited thereto.

In some embodiments, the optical film 10 further includes a glue layer 20 disposed under the lens structure 12, and the lens structure 12 may be attached to a display panel (not shown in FIG. 1) through the glue layer 20, so that the display panel can have a 3D display function. The film stack including the lens structure 12 and the glue layer 20 may be referred to as a lens unit U.

In some embodiments, the glue layer 20 is disposed on a surface S14 of the base layer 14 away from the plurality of lens elements 16. Namely, the glue layer 20 and the plurality of lens elements 16 may be located on opposite sides of the base layer 14. In some embodiments, as shown in FIG. 1, the base layer 14 is disposed between the plurality of lens elements 16 and the glue layer 20, and the plurality of lens elements 16 are disposed between the filling layer 18 and the base layer 14. In some embodiments, as shown in FIG. 1, the glue layer 20 is in direct contact with the base layer 14, and a refractive index difference between the glue layer 20 and the base layer 14 is smaller than 0.2 to reduce the interface reflection at the interface between the glue layer 20 and the base layer 14.

In some embodiments, the optical film 10 further includes a protection layer 22 disposed on the lens structure 12 (or on the lens unit U). The protection layer 22 is disposed on a side of the lens structure 12 away from the glue layer 20 to protect the underlying layers. Namely, the protection layer 22 and the glue layer 20 are located on opposite sides of the lens structure 12. In some embodiments, as shown in FIG. 1, the protection layer 22 is in direct contact with the filling layer 18, and a refractive index difference between the protection layer 22 and the filling layer 18 is smaller than 0.2 to reduce the interface reflection at the interface between the protection layer 22 and the filling layer 18.

The protection layer 22 can be a single layer or multiple layers. For example, the protection layer 22 may include a cover glass or one or more insulating layers, but not limited thereto. In other embodiments, although not shown in FIG. 1, the optical film 10 further includes one or more function layers disposed on the protection layer 22. The one or more function layers includes, for example, a hard coating layer, an anti-reflection layer, an anti-fouling layer, a combination thereof, or the like.

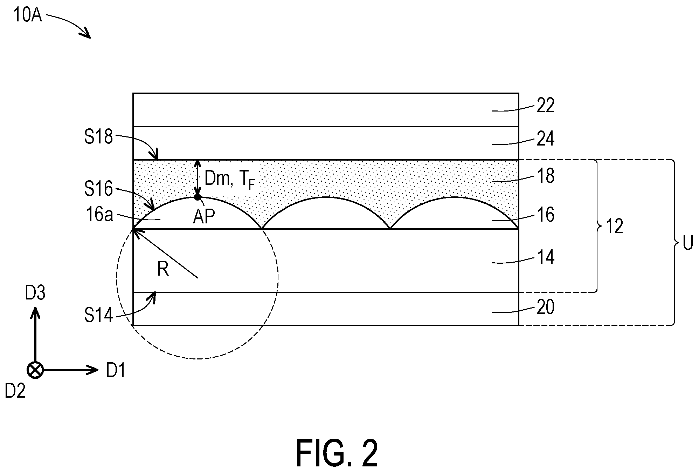

In some embodiments, as shown in FIG. 2, an optical film 10A further includes a glue layer 24 disposed between the lens structure 12 and the protection layer 22. The protection layer 22 may be attached to the filling layer 18 through the glue layer 24, and opposite surfaces (e.g., top and bottom surfaces) of the glue layer 24 are in direct contact with the protection layer 22 and the filling layer 18, respectively. A refractive index difference between the protection layer 22 and the glue layer 24 may be smaller than 0.2 to reduce the interface reflection at the interface between the protection layer 22 and the glue layer 24, and a refractive index difference between the glue layer 24 and the filling layer 18 may be smaller than 0.2 to reduce the interface reflection at the interface between the glue layer 24 and the filling layer 18.

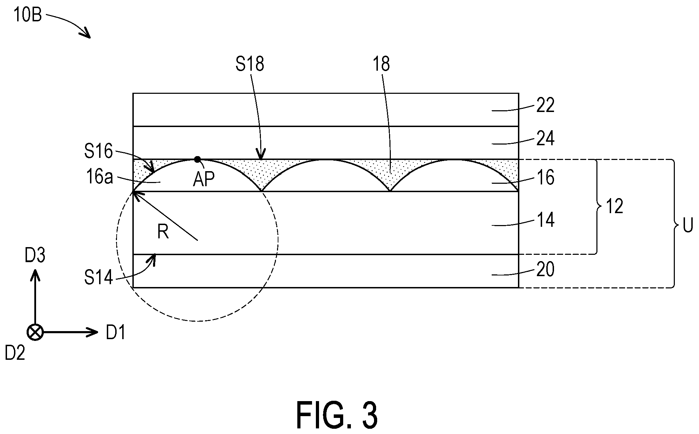

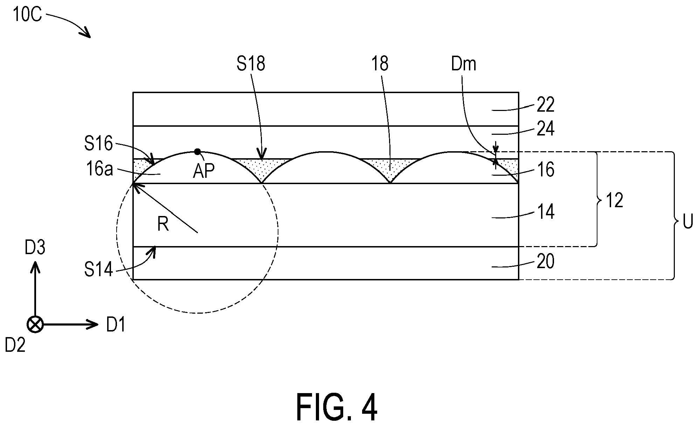

In some embodiments, in an optical film 10B as shown in FIG. 3, the minimum distance Dm (shown in FIG. 1 or FIG. 2) may be equal to zero, and the apex AP may be aligned with the surface S18 (e.g., top surface) of the filling layer 18. In these embodiments, a refractive index difference between the glue layer 24 and the filling layer 18 is less than 0.1 to reduce the impact on the light refraction effect of the plurality of lens elements 16 due to the refractive index difference. In other embodiments, in an optical film 10C as shown in FIG. 4, the filling layer 18 may be thinner than the plurality of lens elements 16, such that the apex AP is higher than the surface S18 of the filling layer 18 and located in the glue layer 24, and a minimum distance Dm between the apex AP and the surface S18 is greater than 0.1µm and smaller than 100µm. In those embodiments, the refractive index difference between the glue layer 24 and the filling layer 18 is also less than 0.1 to reduce the impact on the light refraction effect of the plurality of lens elements 16 due to the refractive index difference.

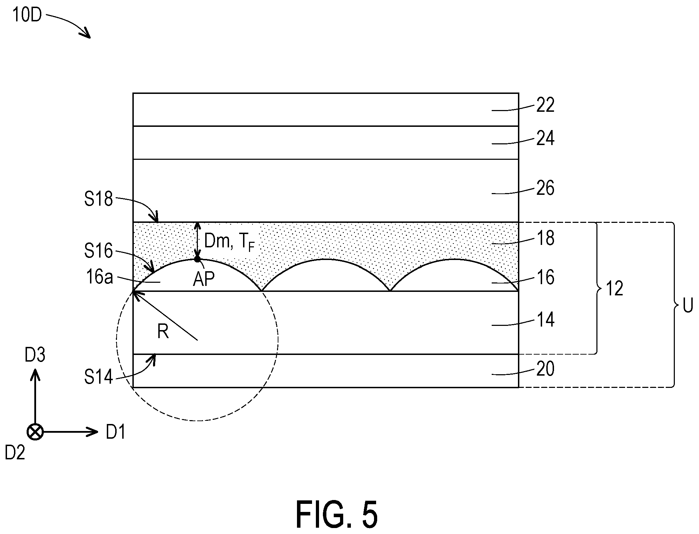

In some embodiments, as shown in FIG. 5, an optical film 10D further includes another base layer (e.g., a base layer 26) disposed between the lens structure 12 and the glue layer 24. Specifically, the glue layer 24 is disposed between the protection layer 22 and the lens unit U, and the base layer 26 is disposed between the glue layer 24 and the lens unit U. In some embodiments, opposite surfaces (e.g., top and bottom surfaces) of the glue layer 24 are in direct contact with the protection layer 22 and the base layer 26, respectively. A refractive index difference between the protection layer 22 and the glue layer 24 may be smaller than 0.2 to reduce the interface reflection at the interface between the protection layer 22 and the glue layer 24, and a refractive index difference between the glue layer 24 and the base layer 26 may be smaller than 0.2 to reduce the interface reflection at the interface between the glue layer 24 and the base layer 26.

By sandwiching the plurality of lens elements 16 and the filling layer 18 between the base layer 26 and the base layer 14, the problem of optical film warping can be improved. The thickness and/or material of the base layer 26 and the base layer 14 may be the same or different.

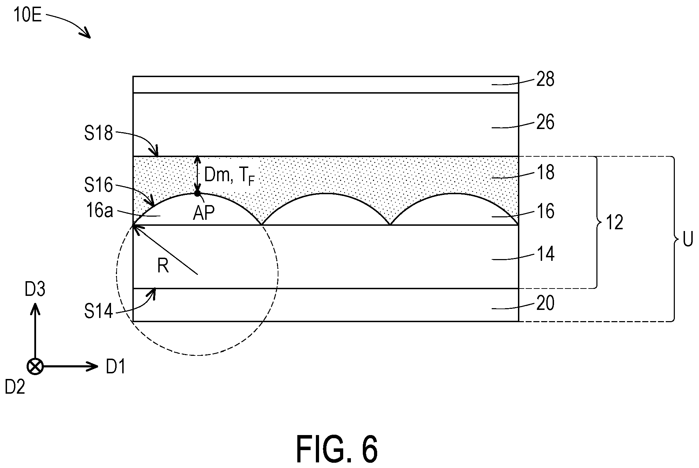

In some embodiments, as shown in FIG. 6, an optical film 10E does not include the protection layer 22 and the glue layer 24 shown in FIG. 5, and the base layer 26 may serve as the protection layer. In some embodiments, as shown in FIG. 6, the optical film 10E further includes a function layer 28 disposed on the base layer 26. The function layer 28 and the filling layer 18 are disposed on opposite surfaces of the base layer 26. The function layer 28 may include a hard coating layer, an anti-reflection layer, an anti-fouling layer, a combination thereof, or the like.

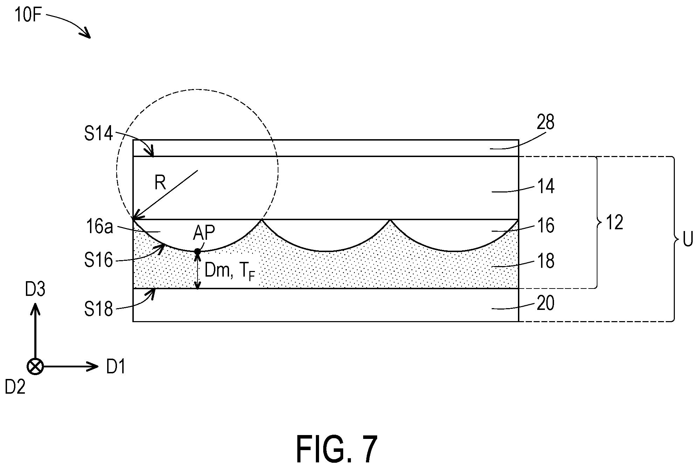

In some embodiments, as shown in FIG. 7, an optical film 10F includes the lens unit U and the function layer 28 disposed on the lens unit U, wherein the filling layer 18 is disposed between the plurality of lens elements 16 and the glue layer 20, and the plurality of lens elements 16 are disposed between the base layer 14 and the filling layer 18. The glue layer 20 may be disposed on the flat surface (the surface S18) of the filling layer 18. In some embodiments, the glue layer 20 is in direct contact with the filling layer 18, and a refractive index difference between the glue layer 20 and the filling layer 18 is smaller than 0.2 to reduce the interface reflection at the interface between the glue layer 20 and the filling layer 18.

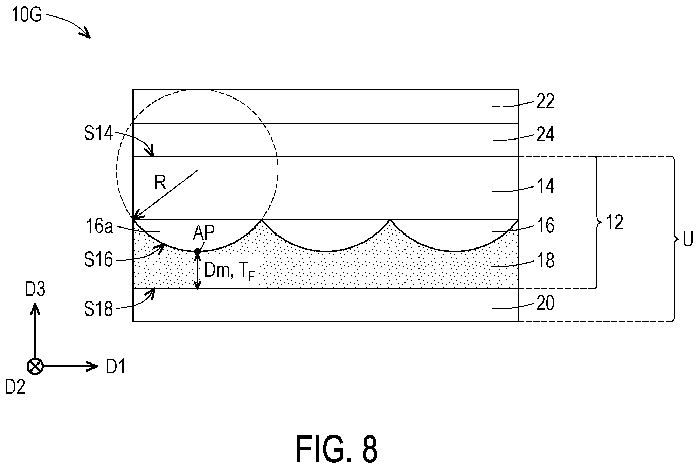

In some embodiments, as shown in FIG. 8, an optical film 10G does not include the function layer 28 in FIG. 7 and further includes the protection layer 22 and the glue layer 24, wherein the protection layer 22 is disposed on the lens unit U, and the glue layer 24 is disposed between the protection layer 22 and the base layer 14. In some embodiments, the protection layer 22 may be attached to the base layer 14 through the glue layer 24, and opposite surfaces (e.g., top and bottom surfaces) of the glue layer 24 are in direct contact with the protection layer 22 and the base layer 14, respectively. A refractive index difference between the protection layer 22 and the glue layer 24 may be smaller than 0.2 to reduce the interface reflection at the interface between the protection layer 22 and the glue layer 24, and a refractive index difference between the glue layer 24 and the base layer 14 may be smaller than 0.2 to reduce the interface reflection at the interface between the glue layer 24 and the base layer 14.

In other embodiments, although not shown, the optical film 10G further include a function layer disposed on a surface of the protection layer 22 away from the glue layer 24, and the function layer may include a hard coating layer, an anti-reflection layer, an anti-fouling layer, a combination thereof, or the like.

Please refer to FIG. 9, a display device 30 includes a display panel 32 and a lens unit U. The display panel 32 includes an image formation surface S1, a top surface S2, and N layers (e.g., a first layer L1 to the N^{th} layer LN) between the image formation surface S1 and the top surface S2, wherein N is a positive integer greater than 1. A thickness of an i^{th} layer among the N layers is Tᵢ, a refractive index of the i^{th} layer among the N layers is nᵢ, and i= 1 to N. The lens unit U includes a base layer 14, a plurality of lens elements 16, a filling layer 18, and a glue layer 20. The glue layer 20 is in direct contact with the top surface S2. The filling layer 18 is in direct contact with the plurality of lens elements 16. A thickness of the base layer 14 is T_{B}, and a refractive index of the base layer is n_{B}. A thickness of the glue layer 20 is T_{G}, and a refractive index of the glue layer is n_{G}. A refractive index of the filling layer 18 is n_{F}. A maximum thickness of a lens element 16a among the plurality of lens elements 16 is T_{L}, and a refractive index of the lens element is n_{L}, and a focal length of the lens element 16a is FL. The lens element 16a includes an arc-shaped surface S16, a radius of curvature of the arc-shaped surface S16 is R, and the arc-shaped surface S16 has an apex AP. An optical gap between the image formation surface S1 and the apex AP is D_{OG}. ${D}_{OG} = \frac{{T}_{G}}{{n}_{G}} + \frac{{T}_{B}}{{n}_{B}} + \frac{{T}_{L}}{{n}_{L}} + {\sum }_{i = 1}^{N} \frac{{T}_{i}}{{n}_{i}} , FL = \frac{R ∗ {n}_{F}}{{n}_{L} - {n}_{F}}$, n_{F} < n_{L} , and (0.8* D_{OG}) < FL < (1.2* D_{OG}).

The image formation surface S1 can be the surface of a layer where the light pattern is defined at the pixel level. For example, in embodiments in which the display panel 32 is a liquid crystal display panel or an organic light emitting diode (OLED) display panel, the image formation surface S1 may be the top surface of a black matrix layer (or a light shielding layer LS shown in FIG. 10 or FIG. 11) or a top surface of a color filter layer. In embodiments in which the display panel 32 is a mini light emitting diode (LED) display panel or a micro LED display panel, the image formation surface S1 may be a horizontal plane where top surfaces of the mini or micro LEDs are located or a virtual plane formed by tops of optical elements (e.g., lenses) covering the mini or micro LEDs.

The N layers between the image formation surface S1 and the top surface S2 may be two or more layers. In some embodiments, N is smaller than 100. The N layers may include one or more substrates, one or more glue layers, one or more optical layers (e.g., polarizer, wavelength conversion layer, or the like), one or more function layers (e.g., protection layer, hard coating layer, anti-reflection layer, anti-fouling layer, or the like), one of more touch sensing layers, one of more passivation layers, or a combination thereof. FIG. 9 schematically illustrates the first layer L1 and the N^{th} layer LN, while other layers between the first layer L1 and the N^{th} layer LN are omitted.

The optical gap D_{OG} between the image formation surface S1 and the apex AP is determined based on the thicknesses and refractive indices of the layers between the image formation surface S1 and the apex AP. Specifically, ${D}_{OG} = \frac{{T}_{G}}{{n}_{G}} + \frac{{T}_{B}}{{n}_{B}} + \frac{{T}_{L}}{{n}_{L}} + {\sum }_{i = 1}^{N} \frac{{T}_{i}}{{n}_{i}}$, wherein ${\sum }_{i = 1}^{N} \frac{{T}_{i}}{{n}_{i}} = \frac{{T}_{1}}{{n}_{1}} + \frac{{T}_{2}}{{n}_{2}} + \frac{{T}_{3}}{{n}_{3}} + ⋯ + \frac{{T}_{N - 1}}{{n}_{N - 1}} + \frac{{T}_{N}}{{n}_{N}}$*.* For example, if N=3, then ${D}_{OG} = \frac{{T}_{G}}{{n}_{G}} + \frac{{T}_{B}}{{n}_{B}} + \frac{{T}_{L}}{{n}_{L}} + \frac{{T}_{1}}{{n}_{1}} + \frac{{T}_{2}}{{n}_{2}} + \frac{{T}_{3}}{{n}_{3}}$ . If N=4, then ${D}_{OG} = \frac{{T}_{G}}{{n}_{G}} + \frac{{T}_{B}}{{n}_{B}} + \frac{{T}_{L}}{{n}_{L}} + \frac{{T}_{1}}{{n}_{1}} + \frac{{T}_{2}}{{n}_{2}} + \frac{{T}_{3}}{{n}_{3}} + \frac{{T}_{4}}{{n}_{4}}$. The focal length FL of each of the plurality of lens elements 16 is determined based on the refractive indices of the plurality of lens elements 16 and the filling layer 18. Besides, the focal length FL of each of the plurality of lens elements 16 may be designed to be larger than 0.8* D_{OG} and smaller than 1.2* D_{OG} so as to optimize lens focus range, thereby collimating light from the pixels PX (shown in FIG. 10 or FIG. 11).

In some embodiments, as shown in FIG. 10 or FIG. 11, a lens pitch PT16 is designed to be larger than 1 pixel size PZ and smaller than 7 pixel sizes PZ so as to optimize the image resolution. A pixel PX may include a plurality of subpixels, FIG. 10 and FIG. 11 schematically illustrate that the pixel PX includes a red subpixel R, a green subpixel G, and a blue subpixel B, but the disclosure is not limited thereto. In some embodiments, the lens pitch PT16 can be a non-integer multiple of the pixel size PZ to improve moiré patterns.

In some embodiments, as shown in FIG. 10, the subpixels are rectangular, wherein a width W1 of the subpixel along the direction D1 is shorter than a width W2 of the subpixel along the direction D2. For example, the W1/W2 <0.5. In these embodiments, an angle θ between the extension direction (the direction D4) of the plurality of lens elements 16 and the direction D2 may be equal to or larger than 5 degrees and equal to or smaller than 45 degrees. This angle design range has covered a lamination deviation between 0.1 degrees to 5 degrees. After the optical film 10 is laminated with the display panel 32 (as shown in FIG. 9), as long as the angle θ is within this design range, a stereoscopic display (3D display) can be achieved through subsequent software correction.

In some embodiments, as shown in FIG. 11, the subpixels are squares, wherein the width W1 of the subpixel along the direction D1 is equal to or close to the width W2 of the subpixel along the direction D2. For example, the 0.5 <W1/W2 <2. In these embodiments, the angle θ between the extension direction (the direction D4) of the plurality of lens elements 16 and the direction D2 may be equal to or larger than 5 degrees and equal to or smaller than 85 degrees. This angle design range covers a lamination deviation between 0.1 degrees to 5 degrees. After the optical film 10 is laminated with the display panel 32 (as shown in FIG. 9), as long as the angle θ is within this design range, a stereoscopic display (3D display) can be achieved through subsequent software correction.

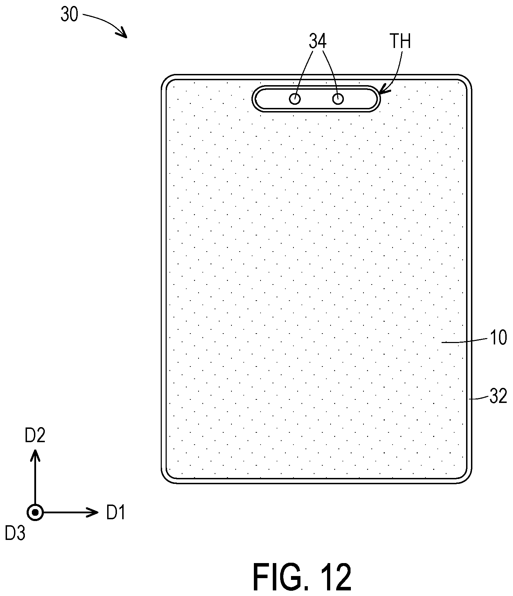

In some embodiments, as shown in FIG. 12, the display panel 32 includes cameras 34, and the optical film 10 includes a through hole TH exposing the cameras 34 of the display panel 32 to reduce the adverse effects of optical film 10 (especially the plurality of lens elements 16 described above) on the cameras 34.

Please refer to FIG. 13, a display device 40 includes a display panel 32 and a lens unit U. The display panel 32 includes an image formation surface S1, a top surface S2, and N layers (e.g., a first layer L1 to the N^{th} layer LN) between the image formation surface S1 and the top surface S2, wherein N is a positive integer greater than 1. A thickness of an i^{th} layer among the N layers is Tᵢ, a refractive index of the i^{th} layer among the N layers is nᵢ, and i= 1 to N. The lens unit U includes a base layer 14, a plurality of lens elements 16, a filling layer 18, and a glue layer 20. The glue layer 20 is in direct contact with the top surface S2. The filling layer 18 is in direct contact with the plurality of lens elements 16. A thickness of the glue layer 20 is T_{G}, and a refractive index of the glue layer 20 is n_{G}. A minimum thickness of the filling layer 18 is T_{F}, and a refractive index of the filling layer 18 is n_{F}. A refractive index of a lens element 16a among the plurality of lens elements 16 is n_{L}, and a focal length of the lens element 16a is FL. The lens element 16a includes an arc-shaped surface S16, a radius of curvature of the arc-shaped surface S16 is R, and the arc-shaped surface S16 has an apex AP. An optical gap between the image formation surface S1 and the apex AP is D_{OG}. ${D}_{OG} = \frac{{T}_{G}}{{n}_{G}} + \frac{{T}_{F}}{{n}_{F}} + {\sum }_{i = 1}^{N} \frac{{T}_{i}}{{n}_{i}} , FL = \frac{R ∗ {n}_{F}}{{n}_{L} - {n}_{F}}$, n_{F} < n_{L} , and (0.8* D_{OG}) < FL < (1.2* D_{OG}).

The detail of the display panel 32 may refer to the description above and will be omitted here. The main difference between the display device 40 and the display device 30 in FIG. 9 lies in the layers between the image formation surface S1 and the apex AP and the relative arrangement of these layers. Therefore, the optical gap D_{OG} in FIG. 9 and FIG. 13 are different.

According to different needs, the display devices in various embodiments of the disclosure may be mobile phones, tablets, other mobile devices, public displays, etc. In addition, the optical film 10 in FIG. 9 may be replaced by any other optical films shown in FIG. 2 to FIG. 6. Moreover, the optical film 10F in FIG. 13 may be replaced by the optical film 10G shown in FIG.8.

In summary, in the embodiments of the disclosure, the lens unit or the lens structure is attached to the display panel to achieve 3D display, wherein the filling layer is in direct contact with the plurality of lens elements to reduce interface reflection. In some embodiments, a protection layer of a base layer is further included to protect the lens unit or the lens structure against scratches, dust, oil, or the like. In some embodiments, the focal length and the optical gap are designed to satisfy a specific relationship to optimize lens focus range, thereby collimating light from the pixels. In some embodiments, the lens pitch and the pixel size are designed to satisfy a specific relationship to optimize the image resolution. In some embodiments, the lens pitch can be a non-integer multiple of the pixel size to improve moiré patterns. In some embodiments, the slant angle of the plurality of lens elements is designed according to the shape of the subpixels so as to allow tolerance for lamination and/or to maximize the number of pixels covered by each lens element, thereby optimize the image resolution. In some embodiments, the optical film includes a through hole exposing cameras of the display panel to reduce the adverse effects of optical film on the cameras.

## Claims

1. A display device (30), comprising:
a display panel (32) comprising an image formation surface (S1), a top surface (S2), and N layers (L1 to LN) between the image formation surface (S1) and the top surface (S2), wherein N is a positive integer greater than 1, a thickness of an i^{th} layer among the N layers (L1 to LN) is Tᵢ, a refractive index of the i^{th} layer among the N layers (L1 to LN) is nᵢ, and i= 1 to N; and
a lens unit (U) comprising a base layer (14), a plurality of lens elements (16), a filling layer (18), and a glue layer (20), wherein:
the glue layer (20) is in direct contact with the top surface (S2),
the filling layer (18) is in direct contact with the plurality of lens elements (16),
a thickness of the base layer (14) is T_{B}, and a refractive index of the base layer (14) is n_{B},
a thickness of the glue layer (20) is T_{G}, and a refractive index of the glue layer (20) is n_{G},
a refractive index of the filling layer (18) is n_{F},
a maximum thickness of a lens element (16a) among the plurality of lens elements (16) is T_{L}, and a refractive index of the lens element (16a) is n_{L}, and a focal length of the lens element (16a) is FL,
the lens element (16a) comprises an arc-shaped surface (S16), a radius of curvature of the arc-shaped surface (S16) is R, and the arc-shaped surface (S16) has an apex (AP),
an optical gap between the image formation surface (S1) and the apex (AP) is D_{OG}, ${D}_{OG} = \frac{{T}_{G}}{{n}_{G}} + \frac{{T}_{B}}{{n}_{B}} + \frac{{T}_{L}}{{n}_{L}} + {\sum }_{i = 1}^{N} \frac{{T}_{i}}{{n}_{i}} ,$ $FL = \frac{R ∗ {n}_{F}}{{n}_{L} - {n}_{F}} , {n}_{F} < {n}_{L} ,$ and (0.8* D_{OG}) < FL < (1.2* D_{OG}).

2. The display device (30) according to claim 1, wherein a minimum thickness (T_{F}) of the filling layer (18) is greater than 0.1µm.

3. The display device (30) according to claim 1 or 2, wherein the glue layer (20) is in direct contact with the base layer (14), and a refractive index difference between the glue layer (20) and the base layer (14) is smaller than 0.2.

4. The display device (30) according to any one of claims 1 to 3, further comprising:
a protection layer (22) disposed on the lens unit (U).

5. The display device (30) according to claim 4, wherein the protection layer (22) is in direct contact with the filling layer (18), and a refractive index difference between the protection layer (22) and the filling layer (18) is smaller than 0.2.

6. The display device (30) according to claim 4, further comprising:
another glue layer (24) disposed between the protection layer (22) and the lens unit (U), wherein:
a refractive index difference between the protection layer (22) and the another glue layer (24) is smaller than 0.2.

7. The display device (30) according to claim 4, further comprising:
another glue layer (24) disposed between the protection layer (22) and the lens unit (U); and
another base layer (26) disposed between the another glue layer (24) and the lens unit (U), wherein:
a refractive index difference between the protection layer (22) and the another glue layer (24) is smaller than 0.2, and
a refractive index difference between the another glue layer (24) and the another base layer (26) is smaller than 0.2.

8. The display device according to any one of claims 1 to 7, wherein the base layer (14) is disposed between the plurality of lens elements (16) and the glue layer (20), and the plurality of lens elements (16) are disposed between the filling layer (18) and the base layer (14).

9. A display device (40), comprising:
a display panel (32) comprising an image formation surface (S1), a top surface (S2), and N layers (L1 to LN) between the image formation surface (S1) and the top surface (S2), wherein N is a positive integer greater than 1, a thickness of an i^{th} layer among the N layers (L1 to LN) is Tᵢ, a refractive index of the i^{th} layer among the N layers (L1 to LN) is nᵢ, and i= 1 to N; and
a lens unit (U) comprising a base layer (14), a plurality of lens elements (16), a filling layer (18), and a glue layer (20), wherein:
the glue layer (20) is in direct contact with the top surface (S2),
the filling layer (18) is in direct contact with the plurality of lens elements (16),
a thickness of the glue layer (20) is T_{G}, and a refractive index of the glue layer (20) is n_{G},
a minimum thickness of the filling layer (18) is T_{F}, and a refractive index of the filling layer (18) is n_{F},
a refractive index of a lens element (16a) among the plurality of lens elements (16) is n_{L}, and a focal length of the lens element (16a) is FL,
the lens element (16a) comprises an arc-shaped surface (S16), a radius of curvature of the arc-shaped surface (S16) is R, and the arc-shaped surface (S16) has an apex (AP),
an optical gap between the image formation surface (S1) and the apex (AP) is D_{OG}, ${D}_{OG} = \frac{{T}_{G}}{{n}_{G}} + \frac{{T}_{F}}{{n}_{F}} + {\sum }_{i = 1}^{N} \frac{{T}_{i}}{{n}_{i}} ,$ $FL = \frac{R ∗ {n}_{F}}{{n}_{L} - {n}_{F}} , {n}_{F} < {n}_{L} ,$ and (0.8* D_{OG}) < FL < (1.2* D_{OG}).

10. The display device (40) according to claim 9, wherein T_{F} is greater than 0.1µm.

11. The display device (40) according to claim 9 or 10, wherein the filling layer (18) is disposed between the plurality of lens elements (16) and the glue layer (20), and the plurality of lens elements (16) are disposed between the base layer (14) and the filling layer (18).

12. An optical film (10, 10A, 10C, 10D, 10E, 10F, 10G), comprising:
a lens structure (12) comprising:
a base layer (14);
a plurality of lens elements (16) disposed on the base layer (12), wherein a refractive index of a lens element (16a) among the plurality of lens elements (16) is n_{L}, the lens element (16a) comprises an arc-shaped surface (S16), and the arc-shaped surface (S16) has an apex (AP); and
a filling layer (18) in direct contact with the plurality of lens elements (16), wherein a refractive index of the filling layer (18) is n_{F}, n_{F} is smaller than n_{L}, the filling layer (18) comprises a flat surface (S18), and a minimum distance (Dm) between the apex (AP) and the flat surface (S18) is greater than 0.1µm and smaller than 100µm.

13. The optical film (10, 10A, 10C, 10D, 10E, 10F, 10G) according to claim 12, further comprising:
a glue layer (20) disposed under the lens structure (12).

14. The optical film (10, 10A, 10C, 10D, 10E) according to claim 13, wherein the glue layer (20) is in direct contact with the base layer (14), and a refractive index difference between the glue layer (20) and the base layer (14) is smaller than 0.2.

15. The optical film (10F, 10G) according to claim 13, wherein the glue layer (20) is in direct contact with the filling layer (18), and a refractive index difference between the glue layer (20) and the filling layer (18) is smaller than 0.2.
